# EUROPEAN PATENT APPLICATION

(11) **EP 1 096 677 A2**
(43) Date of publication of application: **02.05.2001**
(21) Application number: 00123062.2
(22) Date of filing: 24.10.2000
(51) Int. Cl.: H03K 3/356

(54) **Latch circuit with a small number of nodes for high speed operation**

(30) Priority: 27.10.1999 JP 30498799
(71) Applicant: NEC CORPORATION, Tokyo (JP)
(72) Inventor: Kondoo, Toyoo, NEC Yamagata, Ltd., Yamagata-shi, Yamagata (JP)
(74) Representative: Glawe, Delfs, Moll & Partner

(57) **Abstract**

In a latch circuit a differential pair of source-coupled first and second transistors (M1, M2) is provided having their drains connected at circuit nodes (NA, NB) to the drains of third and fourth transistors (M3, M4). The gates of the third and fourth transistors are cross-coupled to the drains of the fourth and third transistors, and their sources are connected to a first voltage terminal (Vcc) for holding a potential developed across the circuit node in response to a pair of complementary input signals supplied to the gates of the first and second transistors (M1, M2). A clock pulse is applied to the gate of a fifth transistor (M5). The source and drain of the fifth transistor are respectively connected to a second voltage terminal (GND) and to the coupled-sources of the first and second transistors (M1, M2) for enabling these transistors in response to the clock pulse.

## Description

### BACKGROUND OF THE INVENTION

### Field of the Invention

The present invention relates to a latch circuit and flip-flop using the latch circuit for high speed operation.

### Description of the Related Art

Japanese Laid-Open Patent Application 10-135792 discloses a master-slave flip-flop as shown in Fig. 1. The prior art flip-flop is implemented with GaAs MESFETs (metal-semiconductor field-effect transistors) and includes a pair of master-side data input transistors 1 and 2. The gates of these input transistors 1 and 2 are connected to data input terminals DT and DC of the flip-flop to which a voltage signal of complementary levels is applied. The sources of transistors 1 and 2 are coupled together to a master-side clock input transistor 15 and their drains are coupled through respective pull-up resistors to a voltage source VDD, forming circuit nodes MN1 and MN2, which are in turn coupled to the gates of master-side holding transistors 3, 4. A pair of master-side stabilizing transistors 5 and 6 are cross-coupled to these holding transistors 3 and 4 by cross-coupling the gates of stabilizing transistors 5 and 6 at nodes MN3 and MN4 to the sources of transistors 4 and 3 and respectively connecting their sources to the gates of transistors 3 and 4, forming nodes MN5 and MN6. Likewise, the slave-side circuitry of the flip-flop includes a pair of data input transistors 7 and 8. The gates of these input transistors are respectively coupled to the nodes MN3 and MN4 of the master-side circuitry and their sources are coupled together to a slave-side clock input transistor 16 and their drains are coupled through respective pull-up resistors to the voltage source VDD, forming circuit nodes SN1 and SN2, which are in turn coupled to the gates of slave-side holding transistors 9, 10. A pair of slave-side stabilizing transistors 11 and 12 are cross-coupled to the slave-side holding transistors 9, 10 by cross-coupling the sources of transistors 11, 12 at nodes SN3 and SN4 to the gates of transistors 9, 10 and respectively connecting the drains of transistors 11 and 12 to the gates of transistors 10 and 9, forming nodes SN6 and SN5. Data output terminals Q1T and Q1C are connected to the nodes SN3 and SN4.

The master-side data input transistors 1, 2 and the slave-side transistors 9, 10, 11 and 12 are enabled when transistor 15 is turned on in response to a clock pulse supplied to terminal CT in order to allow the transistors 1 and 2 to respond to a data input signal at terminals DT and DC. The slave-side data input transistors 7 and 8 and the master-side transistors 3, 4, 5 and 6 are enabled when transistor 16 is turned on in response to a clock pulse supplied to terminal CC in order to allow transistors 7 and 8 to respond to the voltage developed across the nodes MN3 and MN4.

When the transistors 1 and 2 are enabled, a voltage applied to the data input terminals causes a potential change to occur across the nodes MN1 and MN2, which in turn causes the master-side holding transistors 3 and 4 to be activated, producing a potential change cross the nodes MN3 and MN4. When the master-side data stabilizing transistors 5 and 6 are enabled by a subsequent input clock pulse, these data stabilizing transistors operate according to the voltage developed across the nodes MN3 and MN4 to produce a potential change across the nodes MN5 and MN6, which causes the master-side holding transistors 3 and 4 to maintain the potential across the nodes MN3 and MN4. According to the voltage across the nodes MN3 and MN4, the transistors 7 and 8 operate, producing a potential change across the nodes SN1 and SN2. Slave-side data holding transistors 9 and 10 operate according to the voltage across the nodes SN1 and SN2, producing a potential change across the nodes SN3 and SN4. This potential change is maintained by a voltage produced across the nodes SN5 and SN6 by slave-side stabilizing transistors 11 and 12 when the latter is enabled by a subsequent input clock pulse.

For a given input signal, potential changes occur in sequence starting with the first node pair MN1, MN2 (SN1, SN2), and then to the second node pair MN3, MN4 (SN3, SN4). Since the delay time of the flip-flop is equal to the sum of intervals each taken to produce a potential change, it is necessary to reduce the number of nodes in a flip-flop in order to meet the demand for operating flip-flops at high frequencies.

### SUMMARY OF THE INVENTION

It is therefore an object of the present invention to provide a latch circuit with a reduced number of circuit nodes and a flip-flop implemented with the latch circuit.

According to a broader aspect of the present invention, there is provided a latch circuit comprising a differential pair of source-coupled first and second transistors having gates responsive to a pair of complementary input signals, a pair of cross-coupled third and fourth transistors each having a gate and a drain respectively connected to the drain and the gate of the other transistor and having a source connected to a first voltage terminal, the drains of the third and fourth transistors being respectively connected at circuit nodes to drains of the first and second transistors for holding a potential developed across the circuit nodes, and a fifth transistor having a gate for receiving a clock pulse, and having a source connected to a second voltage terminal and a drain connected to the coupled-sources of the first and second transistors for enabling the first and second transistors in response to the clock pulse.

According to a second aspect, the present invention provides a bistable device, or a T flip-flop, which comprises an input circuit for producing a pair of complementary signals in response to an input clock pulse, and first and second latch circuits. Each of the first and second latch circuits includes a differential pair of source-coupled first and second transistors, the first and second transistors of the first latch circuit having drains respectively coupled to gates of the second and first transistors of the second latch circuit and having gates respectively coupled to drains of the first and second transistors of the second latch circuit, a pair of cross-coupled third and fourth transistors each having a gate and a drain respectively connected to the drain and the gate of the other transistor, the third and fourth transistors having sources connected to a first voltage terminal, the drains of the third and fourth transistors being respectively coupled at circuit nodes to the drains of the first and second transistors for holding a potential developed across the circuit nodes. Each latch circuit further includes a fifth transistor having a drain connected to the coupled-sources of the first and second transistors and a source connected to a second voltage terminal, the fifth transistor of the first latch circuit having a gate responsive to one of the pair of complementary signals for enabling the first and second transistors of the first latch circuit and the fifth transistor of the second latch circuit having a gate responsive to the other complementary signal for enabling the first and second transistors of the second latch circuit.

According to a third aspect, the present invention provides a bistable device, or a D flip-flop, which comprises a first input circuit for producing a pair of complementary data signals in response to an input data pulse, a second input circuit for producing a pair of complementary clock signals in response to an input clock pulse, and first and second latch circuits. Each of the first and second latch circuits includes a differential pair of source-coupled first and second transistors, the first and second transistors of the first latch circuit having gates responsive to the pair of complementary data signals and having drains respectively connected to gates of the first and second transistors of the second latch circuit, a pair of cross-coupled third and fourth transistors each having a gate and a drain respectively connected to the drain and the gate of the other transistor, the third and fourth transistors having sources connected to a first voltage terminal, the drains of the third and fourth transistors being respectively connected at circuit nodes to the drains of the first and second transistors for holding a potential developed across the circuit nodes, and a fifth transistor having a drain connected to the coupled-sources of the first and second transistors and a source connected to a second voltage terminal, the fifth transistor of the first latch circuit having a gate responsive to one of the pair of complementary clock signals for enabling the first and second transistors of the first latch circuit, and the fifth transistor of the second latch circuit having a gate responsive to the other complementary clock signal for enabling the first and second transistors of the second latch circuit.

### BRIEF DESCRIPTION OF THE DRAWINGS

The present invention will be described in further detail with reference to the accompanying drawings, in which:
Fig. 1 is a circuit diagram of a prior art master-slave flip-flop;
Fig. 2 is a circuit diagram of a latch circuit according to the present invention;
Fig. 3 is a circuit diagram of a toggle flip-flop using the latch circuit of Fig. 2; and
Fig. 4 is a circuit diagram of a D flip-flop using the latch circuit of Fig.2.

### DETAILED DESCRIPTION

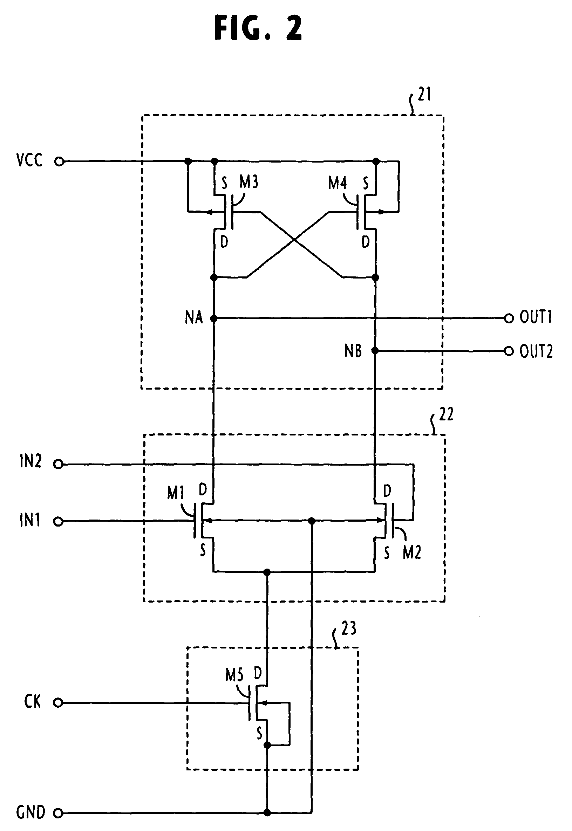

In Fig. 2, there is shown a latch circuit of the present invention which is particularly suitable for complementary MOS (metal oxide semiconductor) structure. The latch circuit is generally comprised by a data holding circuit 21, a data input circuit 22 and a clock circuit 23.

Data holding circuit 1 is formed of a pair of p-channel MOS field effect transistors M3 and M4 for storing a single bit of data at a time. Each of the transistors M3 and M4 has a source connected to a voltage supply terminal Vcc and a gate electrode cross-coupled to the drain of the other transistor. The substrate of transistors M3 and M4 are coupled to the voltage supply terminal Vcc.

Data input circuit 22 includes a differential pair of n-channel MOSFETs M1 and M2. Complementary input signals are supplied through data input terminals IN1 and IN2 to the gate electrode of the transistors M1 and M2 for receiving a single data bit at a time. The substrates of transistors M1 and M2 are connected to ground terminal GND. The drains of transistors M1 and M3 are connected together at node NA and the drains of transistors M2 and M4 are connected together at node NB. Nodes NA and NB are respectively connected to data output terminals OUT1 and OUT2.

Clock circuit 23 is formed by an n-channel MOSFET M5 whose source and substrate are coupled to ground terminal GND and whose gate is coupled to a clock input terminal CK. The drain of transistor M5 is connected to the sources of transistors M1 and M2.

When the clock input terminal CK goes high, the transistor M5 is turned on to enable the transistors M1 and M2. With the transistors M1 and M2 being enabled, a potential change across the data input terminals IN1 and IN2 causes one of the transistors M1 and M2 to turn on and the other to turn off, producing a potential change across the nodes NA and NB. This potential change sets the data holding transistors M3 and M4 in one binary state.

If the data input transistors M1 and M2 are in an OFF state, there is a parasitic capacitance between the paired nodes NA and NB and the ground terminal GND. Since a characteristic of MOS transistors is their exceptionally high input impedance, the parasitic capacitance can be used as a temporary storage capacitor and the mode in which the latch circuit operates is known as dynamic operation. When the clock input terminal CK goes low, the transistor M5 is turned off to disable the transistors M1 and M2. The disabling of the data input circuit 2 allows the potential change set in the data holding transistors M3 and M4 to be stored in the temporary storage capacitor. The voltage stored in the parasitic capacitor determines the binary state of output data, which is withdrawn from the data output terminals OUT1 and OUT2.

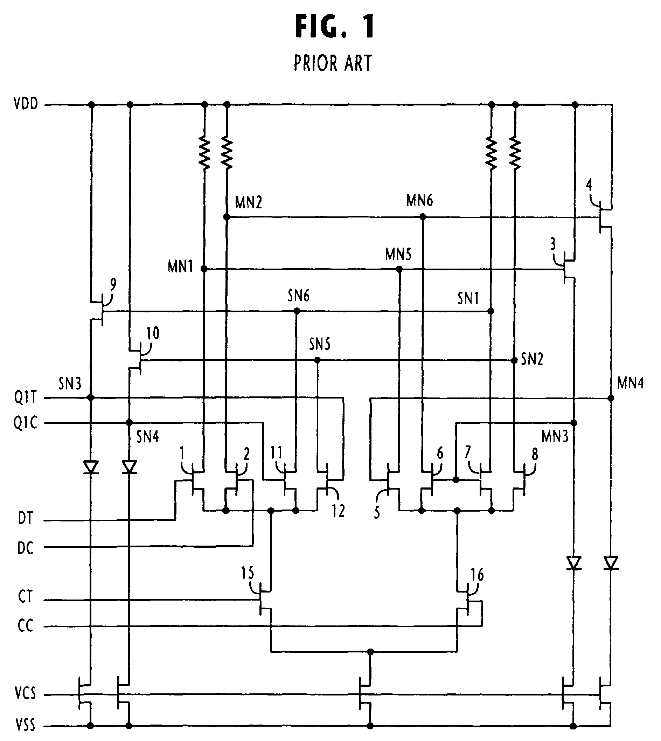

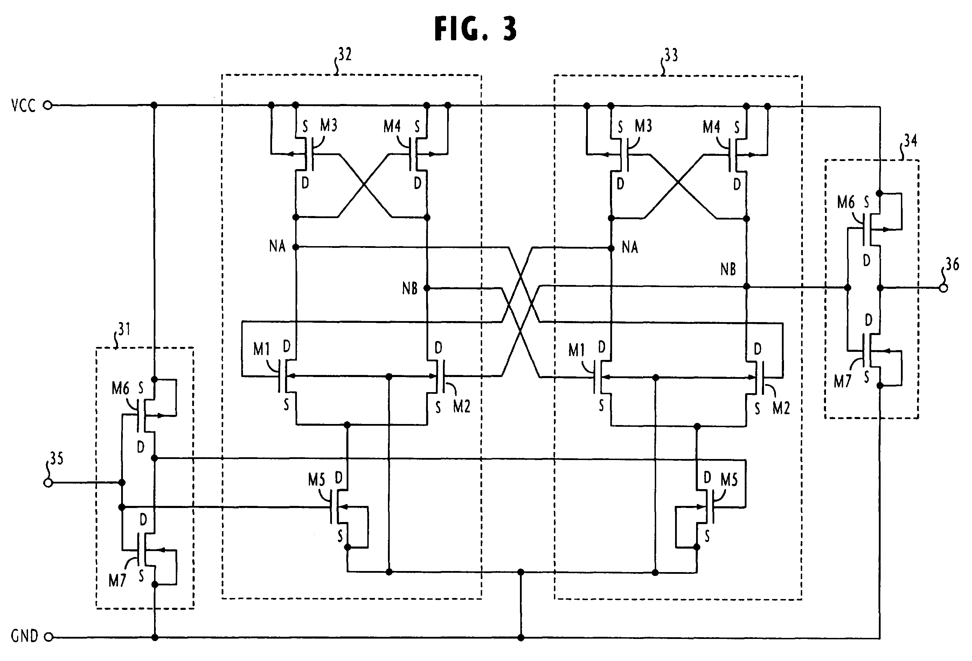

Since there is only one pair of nodes for latching an input binary state, the latch circuit has a short delay time and can be implemented with a reduced number of CMOS transistors. Experiments showed that the latch circuit of Fig. 1 operates at a maximum frequency of 3.3 GHz and at a minimum frequency of 3.3 kHz. The latch circuit of Fig. 2 is used in a toggle flip-flop as shown in Fig. 3. The toggle flip-flop is comprised by an input inverter 31, first and second latch circuits 32 and 33, and an output inverter 34.

The input inverter 31 is formed by a pair of p-channel and n-channel MOSFETs M6 and M7 having their gates coupled together to a data input terminal 35 and to the gate of clock input transistor M5 of the first latch circuit 32, and their drains coupled together to the gate of the clock input transistor M5 of the second latch circuit 33. The sources of transistors M6 and M7 are connected respectively to the voltage terminal Vcc and the ground terminal GND.

The sources of transistors M5 of both latch circuits are connected together to the ground terminal GND. The nodes NA and NB of the first latch circuit 32 are connected to the gates of transistors M2 and M1 of the second latch circuit 33, respectively, and the nodes NA and NB of the second latch circuit 33 are connected to the gates of transistors M1 and M2 of the first latch circuit 32, respectively.

The output inverter 34 is formed by a pair of p-channel and n-channel MOSFETs M8 and M9 having their gates coupled together to the node NB of the second latch circuit 33 and their drains coupled together to a data output terminal 36. The sources of transistors M8 and M9 are connected respectively to the voltage terminal Vcc and the ground terminal GND.

When the voltage at terminal 35 is high, the clock input transistor M5 of the first latch circuit is turned on and enables the associated data input
transistors M1 and M2 to receive a potential developed across the nodes NA
and NB of the second latch 33. The data holding transistors M3 and M4 of the first latch 32 holds the potential developed across the associated nodes NA and NB when the associated data input transistors M1 and M2 are turned off when the input terminal 35 goes low.

As long as the voltage at terminal 35 is low, the clock input transistor M5 of the second latch 33 is turned on and enables the associated data input transistors M1 and M2 to receive the potential developed across the nodes NA and NB of the first latch 32. The data holding transistors M3 and M4 of the second latch 33 holds the potential across the associated nodes NA and NB when the associated data input transistors M1 and M2 are turned off when the input terminal 35 goes high. A voltage pulse developed at the node NB of the second latch 33 is delivered to the data output terminal 36 at one half the frequency of the input voltage pulse.

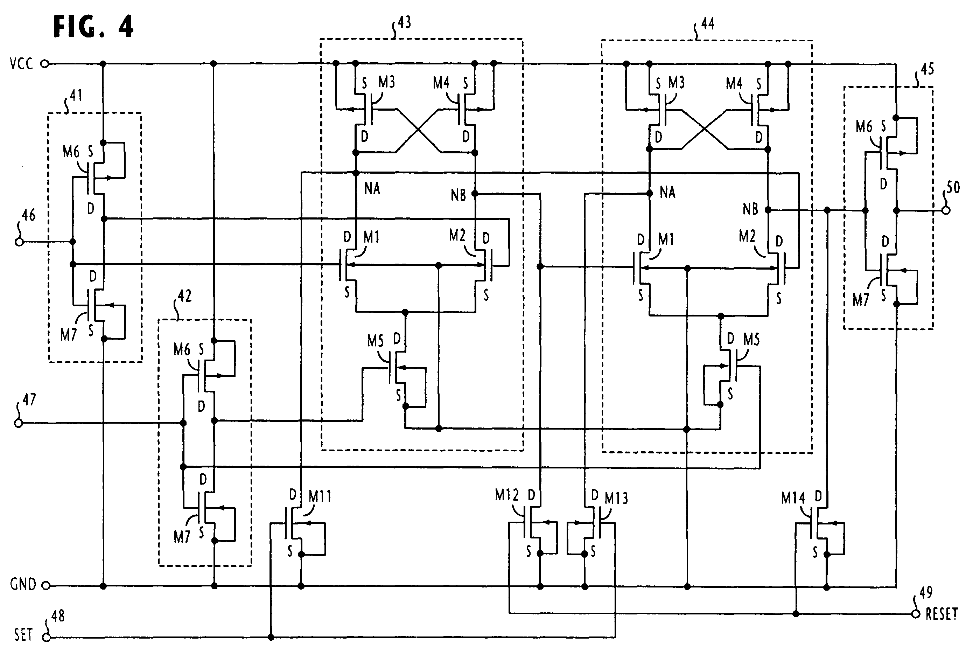

Fig. 4 is a circuit diagram of a D flip-flop using the latch circuit of Fig. 2. The D flip-flop is comprised by CMOS input inverters 41 and 42, first and second latch circuits 43 and 44 and a CMOS output inverter 45. All elements of the flip-flop are connected across the voltage terminal Vcc and the ground terminal GND. All CMOS inverters are identical in structure to the inverters of Fig. 3.

Similar to Fig. 3, the sources of transistors M5 of both latch circuits are connected together to the ground terminal GND. The nodes NA and NB of the first latch circuit 43 are connected to the gates of transistors M2 and M1 of the second latch circuit 44, respectively, and the nodes NA and NB of the second latch circuit 44 are connected to the gates of transistors M1 and M2 of the first latch circuit 43, respectively.

The input of CMOS inverter 41 is connected to a data input terminal 46 to supply a pair of complementary data signals to the gates of data input transistors M1 and M2 of the first latch circuit 43. The input of CMOS inverter 42 is connected to a clock input terminal 47 to supply a pair of complementary clock signals to the gates of clock input transistors M5 of the first and second latch circuits 43 and 44.

A set input signal is supplied through a terminal 48 to the gates of n-channel MOSFETs M11 and M13. The drains of transistors M11 and M13 are connected respectively to the nodes NA of both latch circuits, with their sources being connected to the ground terminal GND. A reset input signal is applied through a terminal 49 to the gates of n-channel MOSFETs M12 and M14. The drains of transistors M12 and M14 are connected respectively to the nodes NB of both latch circuits and their sources are connected to the ground terminal GND. The CMOS output inverter 45 is connected between the node NB of the second latch 44 and a data output terminal 50.

As long as the set and reset input terminals 48 and 49 are both at low level, the D flip-flop receives 1-bit data at the data input terminal 46. In response to a clock input at terminal 47, the first latch circuit 43 is enabled to store the 1-bit data presented at the data input terminal 46. In response to the next clock input, the second latch 44 is enabled to receive the data of the first latch 43. The 1-bit data stored in the second latch 44 is inverted by the output inverter 45 and delivered to the data output terminal 50.

When the set input terminal 48 goes high, a "1" is set in the first and second latch circuits 43 and 44. When the reset input terminal 49 goes high, a "0" is set in the latch circuits 43 and 44. These set and reset operations proceed independently of the logic state at the clock input terminal 47.

## Claims

1. A latch circuit comprising:
a differential pair of source-coupled first and second transistors having gates responsive to a pair of complementary input signals;
a pair of cross-coupled third and fourth transistors each having a gate and a drain respectively connected to the drain and the gate of the other transistor and having a source connected to a first voltage terminal, the drains of said third and fourth transistors being respectively connected at circuit nodes to drains of said first and second transistors for holding a potential developed across the circuit nodes; and
a fifth transistor having a gate for receiving a clock pulse, and having a source connected to a second voltage terminal and a drain connected to the coupled-sources of the first and second transistors for enabling said first and second transistors in response to said clock pulse.

2. The latch circuit of claim 1, wherein said first and second transistors are metal-oxide semiconductor (MOS) transistors of first conductivity type and said third and fourth transistors are MOS transistors of second conductivity type opposite to the first conductivity type, and said fifth transistor is a MOS transistor of said second conductivity type.

3. A bistable device comprising:
an input circuit for producing a pair of complementary signals in response to an input clock pulse; and
first and second latch circuits, each of the latch circuits including:
a differential pair of source-coupled first and second transistors, the first and second transistors of the first latch circuit having drains respectively coupled to gates of said second and first transistors of the second latch circuit and having gates respectively coupled to drains of said first and second transistors of the second latch circuit;
a pair of cross-coupled third and fourth transistors each having a gate and a drain respectively connected to the drain and the gate of the other transistor, the third and fourth transistors having sources connected to a first voltage terminal, the drains of said third and fourth transistors being respectively coupled at circuit nodes to the drains of said first and second transistors for holding a potential developed across the circuit nodes; and
a fifth transistor having a drain connected to the coupled-sources of the first and second transistors and a source connected to a second voltage terminal, the fifth transistor of the first latch circuit having a gate responsive to one of said pair of complementary signals for enabling the first and second transistors of the first latch circuit and the fifth transistor of the second latch circuit having a gate responsive to the other complementary signal for enabling the first and second transistors of the second latch circuit.

4. The bistable device of claim 3, wherein said first and second transistors of each of the first and second latch circuits are metal-oxide semiconductor (MOS) transistors of first conductivity type and said third and fourth transistors of each of the first and second latch circuits are MOS transistors of second conductivity type opposite to the first conductivity type, and said fifth transistor of each of the first and second latch circuits is a MOS transistor of said second conductivity type.

5. The bistable device of claim 4, wherein said input circuit comprises a complementary MOS inverter.

6. A bistable device comprising:
a first input circuit for producing a pair of complementary data signals in response to an input data pulse;
a second input circuit for producing a pair of complementary clock signals in response to an input clock pulse; and
first and second latch circuits, each of the latch circuits including:
a differential pair of source-coupled first and second transistors, the first and second transistors of the first latch circuit having gates responsive to said pair of complementary data signals and having drains respectively connected to gates of the first and second transistors of the second latch circuit;
a pair of cross-coupled third and fourth transistors each having a gate and a drain respectively connected to the drain and the gate of the other transistor, the third and fourth transistors having sources connected to a first voltage terminal, the drains of said third and fourth transistors being respectively connected at circuit nodes to the drains of said first and second transistors for holding a potential developed across the circuit nodes; and
a fifth transistor having a drain connected to the coupled-sources of the first and second transistors and a source connected to a second voltage terminal, the fifth transistor of the first latch circuit having a gate responsive to one of said pair of complementary clock signals for enabling the first and second transistors of the first latch circuit, and the fifth transistor of the second latch circuit having a gate responsive to the other complementary clock signal for enabling the first and second transistors of the second latch circuit.

7. The bistable device of claim 6, wherein said first and second transistors of each of the first and second latch circuits are metal-oxide semiconductor (MOS) transistors of first conductivity type and said third and fourth transistors of each of the first and second latch circuits are MOS transistors of second conductivity type opposite to the first conductivity type, and said fifth transistor of each of the first and second latch circuits is a MOS transistor of said second conductivity type.

8. The bistable device of claim 7, wherein each of said first and second input circuits comprises a complementary MOS inverter.

9. The bistable device of claim 8, further comprising:
a sixth transistor having a drain connected to the drain of the first transistor of the first latch circuit and a source connected to said second voltage terminal, and a gate responsive to a SET signal for setting said first latch circuit to logic one;
a seventh transistor having a drain connected to the drain of the first transistor of the second latch circuit and a source connected to said second voltage terminal, and a gate responsive to the SET signal for setting said second latch circuit to logic one;
an eighth transistor having a drain connected to the drain of the second transistor of the first latch circuit and a source connected to said second voltage terminal, and a gate responsive to a RESET signal for resetting said first latch circuit to logic zero; and
a ninth transistor having a drain connected to the drain of the second transistor of the second latch circuit and a source connected to said second voltage terminal, and a gate responsive to the RESET signal for setting said second latch circuit to logic zero.

10. The bistable device of claim 9, wherein each of said sixth, seventh, eighth and ninth transistors is a MOS transistor of said second conductivity type.
